Europäisches Patentamt

European Patent Office

Office européen des brevets

(19)

(11) **EP 1 168 602 B1**

(12) **EUROPEAN PATENT SPECIFICATION**

(45) Date of publication and mention
of the grant of the patent:
**23.11.2005 Bulletin 2005/47**

(51) Int Cl.⁷: **H03F 3/45**

(21) Application number: **00830439.6**

(22) Date of filing: **23.06.2000**

(54) **Completely differential operational amplifier of the folded cascode type**

Vollständig differentieller gefalteter Kaskodenoperationsverstärker

Amplificateur opérationnel complètement différentiel du type cascode replié

(84) Designated Contracting States:
**DE FR GB IT**

(43) Date of publication of application:
**02.01.2002 Bulletin 2002/01**

(73) Proprietor: **STMicroelectronics S.r.l.**
**20041 Agrate Brianza (Milano) (IT)**

(72) Inventors:
 • **Colonna, Vittorio**
 **27015 Landriano (PV) (IT)**
 • **Baschirotto, Andrea**
 **15057 Tortona (AL) (IT)**
 • **Cusinato, Paolo**
 **16039 Sestri Levante (GE) (IT)**
 • **Gandolfi, Gabriele**
 **27010 Siziano (PV) (IT)**

(74) Representative: **Mittler, Enrico et al**
**Mittler & C. s.r.l.,**
**Viale Lombardia, 20**
**20131 Milano (IT)**

(56) References cited:
 **EP-A- 0 664 608**     **US-A- 5 748 040**

## Description

The present invention refers to a completely differential operational amplifier of the folded cascode type.

In applications where it is necessary to have high gain in continuous (DC) without bandwidth restrictions single stage amplifiers are used with the output transistors cascode connected and with a feedback loop for each output transistor, to increase the output impedance. These feedback loops are commonly called gain amplifier circuits (gain boosting circuits) because of their function.

A completely differential operational amplifier with single stage includes four output transistors (two for each output), therefore that determines the use of four feedback loops which normally are realized by means of four unbalanced operational amplifiers.

As disclosed in the American patent US 5,748,040 a further realization of the feedback loops is effected by replacing the four individual output operational amplifiers with two differential operational amplifiers. The principal advantages of this realization are an inferior current consumption and the use of a smaller silicon area.

In view of the state of the art described, it is an object of the present invention to further reduce the current consumption and the use of a smaller silicon area.

According to the present invention, these and other objects are achieved by means of a completely differential operational amplifier of the folded cascode type comprising a differential output stage; a differential input stage able to drive said output stage; said differential output stage includes a first branch having at least a first and a second transistor, and a second branch having at least a third and a fourth transistor; said first and second branch are coupled to a first and to a second feeding voltage; a feedback circuit of said first, second, third and fourth transistors; characterized in that said feedback circuit is constituted by a single amplifier having four inputs and four outputs, said four inputs take the voltage present on a terminal of said first, second, third and fourth transistors, and said four outputs provide each a voltage to the control elements of said first, second, third and fourth transistors, which depends on the value of the input voltage of said four inputs.

Such objects are also achieved by means of an amplifier having four inputs and four outputs able to provide an output voltage that depends on the value of the input voltage of said four inputs; characterized in that said amplifier includes a first differential couple composed of a first and a second transistor having the drain respectively connected to two output terminals and coupled to the positive feeding voltage through two current generators; the gate of said first and second transistor are coupled to two input terminals; a second differential couple composed of a third and a fourth transistor having the drain connected respectively to two output terminals and coupled to the negative voltage feeding through two current generators; the gate of said third and fourth transistors are coupled to two input terminals; the source of said first, second, third and fourth transistor are connected together; a voltage generator is applied between the positive voltage feeding and said source.

The features and the advantages of the present invention will be made more evident by the following detailed description of a particular embodiment, illustrated as a non-limiting example in the annexed drawings, wherein:

the Figure 1 illustrates a schematic circuit of a completely differential operational amplifier of the folded cascode type according to the known art;
the Figure 2 illustrates a schematic circuit of a completely differential operational amplifier of the folded cascode type according to the present invention;
the Figure 3 illustrates a schematic circuit of an amplifier having four inputs and four outputs according to the present invention;
the Figure 4 illustrates a schematic circuit of a further embodiment of an amplifier having four inputs and four outputs according to the present invention.

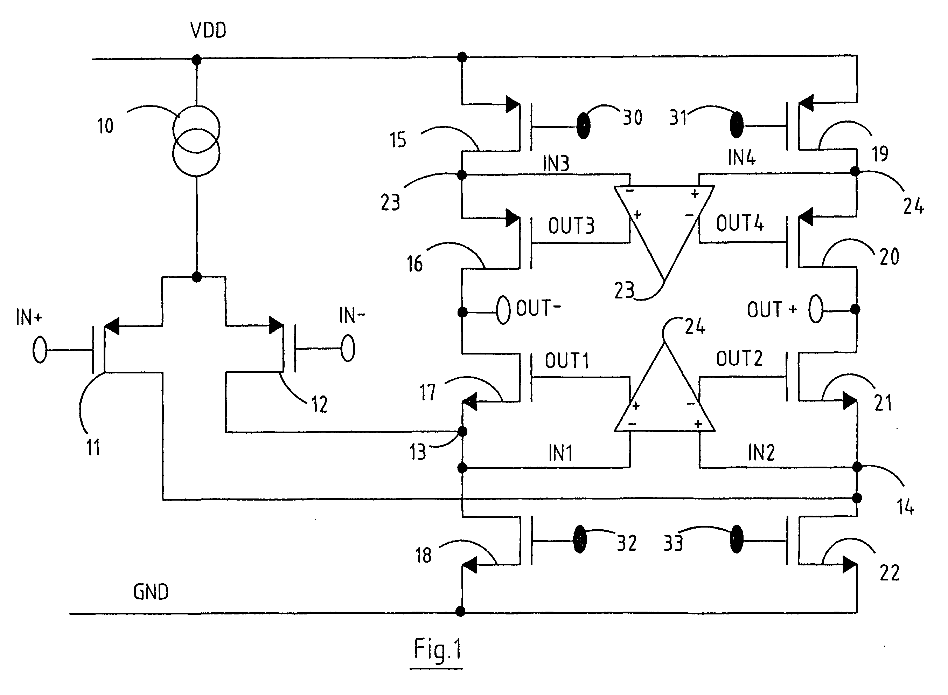

Referring to Figure 1, it is illustrated a schematic circuit of a completely differential operational amplifier of the folded cascode type according to the known art. A differential couple of transistors 11 and 12 are connected in a common source configuration with the sources connected to a terminal of a current generator 10, the other terminal is connected to a feeding voltage VDD. The drain of the transistor 11 is connected to a node 14 and the drain of the transistor 12 is connected to a node 13. The gate of the transistor 11 is connected to a positive input IN+ and the gate of the transistor 12 is connected to an negative input IN-.

To the node 13 is connected the drain of a transistor 18, its source is connected to ground GND; to the node 14 is connected the drain of a transistor 22, its source is connected to ground GND.

To the feeding voltage VDD is connected the source of a transistor 15, its drain is connected to a node 23; to the feeding voltage VDD is also connected the source of a transistor 19, its drain is connected to a node 24. The gates 30, 31, 32 and 33 respectively belonging to the transistors 15, 19, 18 and 22 in the Figure are left open for representation simplicity but they are to be connected to their relative bias voltages not shown, and they explicate the function of current mirrors .

To the node 13 is also connected the source of a transistor 17 whose drain is connected to a negative output terminal OUT-, to this terminal is connected the drain of a transistor 16, whose source is connected to the node 23.

In an analogous way, on the other symmetrical branch, to the node 14 is connected the source of a transistor 21 whose drain is connected to a positive output terminal OUT+, to this terminal is connected the drain of a transistor 20, whose source is connected to the node 24.

An operational amplifier 24 having differential output has an input IN1 connected to the node 13, an input IN2 connected to the node 14, an output OUT1 connected to the gate of the transistor 17, an output OUT2 connected to the gate of the transistor 21. An operational amplifier 23 having differential output has an input IN3 connected to the node 23, an input IN4 connected to the node 24, an output OUT3 connected to the gate of the transistor 16, an output OUT4 connected to the gate of the transistor 20.

The transistors 11, 12, 15, 16, 19 and 20 are, for instance, with a p channel, the transistors 17, 18, 21 and 22 are, for instance, with an n channel.

In Figure 1, and in the following ones, it is represented an example of a completely differential operational amplifier of the folded cascode type, other circuitry configurations are however possible which could be functionally regarded equivalent.

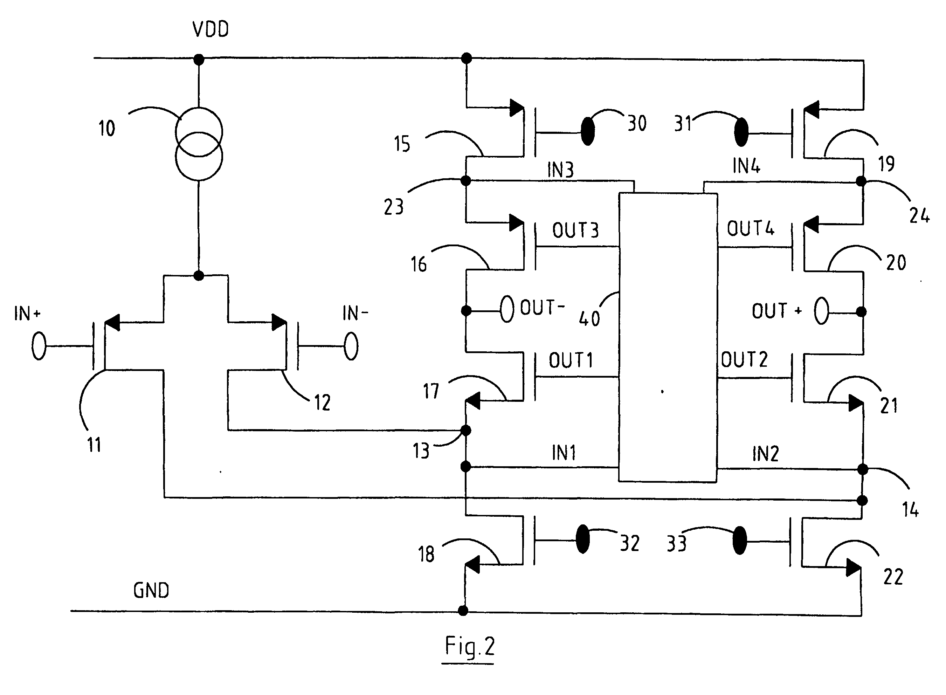

In Figure 2 it is reported a schematic circuit of a completely differential operational amplifier of the folded cascode type according to the present invention. It is of the type reported in Figure 1 therefore the corresponding elements have the same numerical references.

With respect to the scheme of Figure 1 where are shown two operational amplifiers 23 and 24 having differential outputs which form the feedback loops (gain boosting circuits], they have been replaced, in Figure 2, by a single amplifier 40 having four inputs IN1, IN2, IN3 and IN4 and four outputs OUT1, OUT2, OUT3 and OUT4.

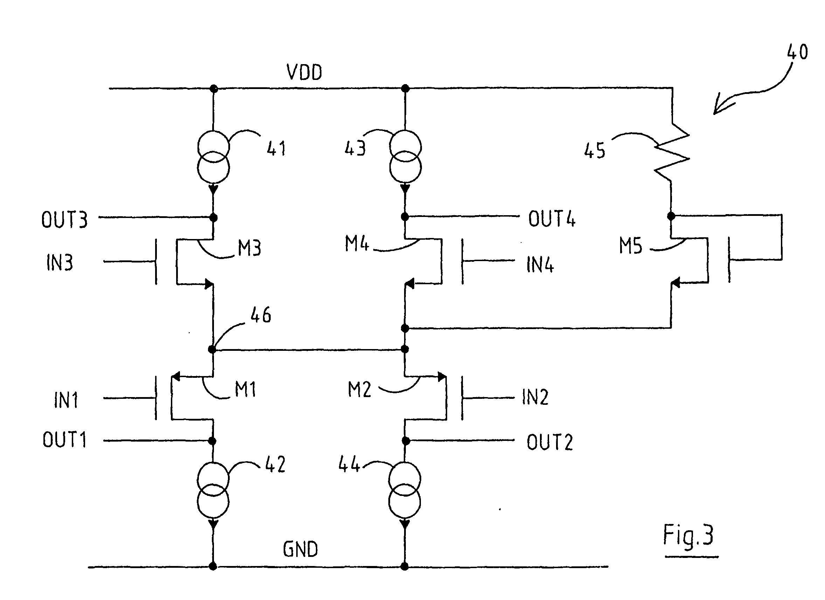

In Figure 3 it is reported a schematic circuit of the amplifier 40 having four inputs and four outputs according to the present invention.

The amplifier 40 is composed of two symmetrical branches, the first branch comprises a current generator 41 connected on a side to the positive feeding VDD and on the other side to the output OUT3 and to the drain of a transistor M3, which gate is connected to the input IN3 and the source is connected to a node 46. To the node 46 is also connected the source of a transistor M1 which gate is connected to the input IN1 and the drain is connected to the output OUT1 and to a side of a current generator 42, the other side is connected to Ground GND. The second branch comprises a current generator 43 connected on a side to the positive feeding VDD and on the other side to the output OUT4 and to the drain of a transistor M4, which gate is connected to the input IN4 and the source is connected to a node 46. To the node 46 is also connected the source of a transistor M2 which gate is connected to the input IN2 and the drain is connected to the output OUT2 and to a side of a current generator 44, the other side is connected to ground GND.

A resistance 45 is connected between the positive feeding VDD and a transistor M5 connected like a diode having the gate and the drain connected to the resistance 45 and the source connected to the node 46.

The transistors M1 and M2 are, for instance, with a p channel, the transistors M3, M4 and M5 are, for instance, with a n channel.

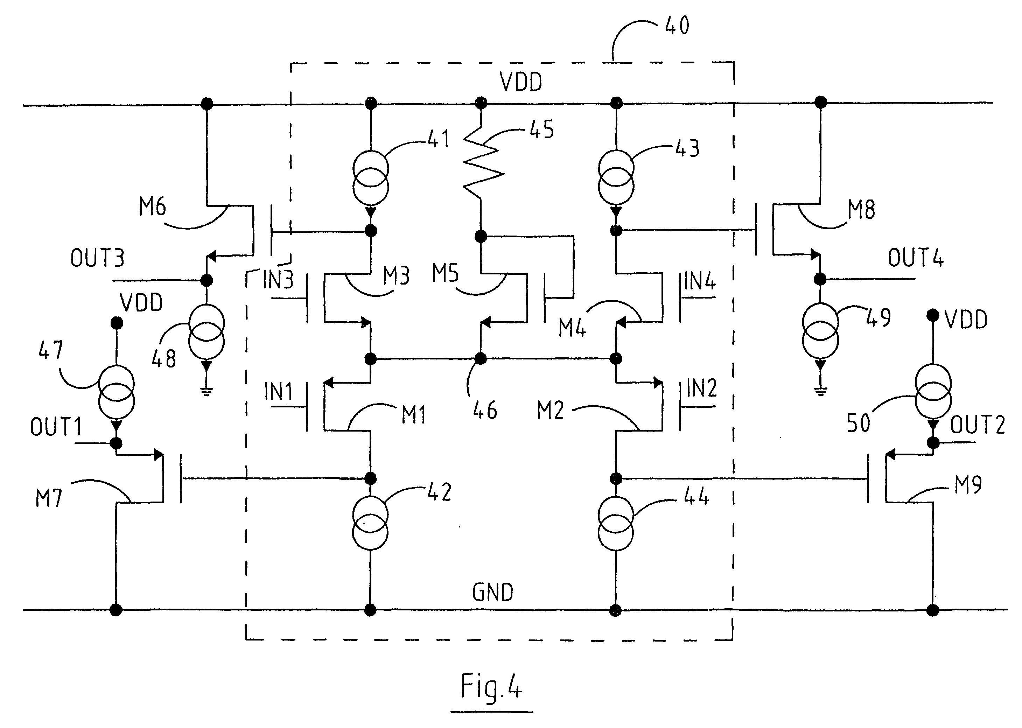

The Figure 4 illustrates a schematic circuit of a further embodiment of the amplifier 40 having four inputs and four outputs according to the present invention. The elements corresponding to those reported in Figure 3 have the same numerical references.

Additionally to the elements of Figure 3, in Figure 4 there is a transistor M6 having the drain connected to the positive feeding voltage VDD the source connected to a current generator 48 in turn connected to ground GND. The gate is connected to the drain of the transistor M3 and the output OUT3 is this time applied to the source of the transistor M6. A transistor M7 having the drain connected to ground GND, the source connected to a current generator 47 in turn connected to the positive feeding voltage VDD. The gate is connected to the drain of the transistor M1 and the output OUT1 is this time applied to the source of the transistor M7.

In an analogous way for the other symmetrical branch we find a transistor M8 having the drain connected to the positive feeding voltage VDD, the source connected to a current generator 49 in turn connected to ground GND. The gate is connected to the drain of the transistor M4 and the output OUT4 is this time applied to the source of the transistor M8. A transistor M9 having the drain connected to ground GND, the source connected to a current generator 50 in turn connected to the feeding voltage VDD. The gate is connected to the drain of the transistor M2 and the positive output OUT2 is this time applied to the source of the transistor M9.

The transistors M7 and M9 are, for instance, with p channel, the transistors M6 and M8 are, for instance, with n channel.

As reported in Figure 4 it is preferable to add the transistors and the current generators on the outputs of the amplifier 40 in order to get some level variations of the output signal. The used transistors work like voltage follower and they therefore can be designed so that they consume low current and occupy a small space.

Returning now to the amplifier having four inputs and four outputs reported in Figure 3, it is to be noted the structure simplicity that allows a low current consumption and a wide bandwidth. Besides a notable reduction of the silicon area has been reached as regards the precedents circuits. It must be considered only a small gain loss in continuous (DC) with respect to a conventional circuit. If we consider that the transconductance (gm) of the transistors M1, M2, M3 and M4 is equal we have:

$$V_{out}(n) = 0.25\ g_m\ r_{DS}(n)\ \text{with}\ n = 1, ..., 4$$

where rDS is the impedance of the output transistor in consideration.

While in the conventional circuits we had:

Vout (n)= 0.5 gm rDS(n) with n= 1, ..., 4

Besides, for the circuit of Figure 3, we have:

Vout1-Vout2= K1 (VIN1 - VIN2) + K2 (VIN3 - VIN4)

where Vout1 and Vout2 are the output voltages respectively of the output OUT1 and OUT2; VIN1, VIN2, VIN3 and VIN4 are the input voltages of the four inputs, respectively IN1, IN2, IN3, IN4; K1 is a first amplification factor and K2 is a second amplification factor, with K1 greater than K2. K1 is about 26 dB and K2 is about 1 dB.
A similar relationship is valid also for the other two outputs and that is

Vout3-Vout4= K1 (VIN3 - VIN4) + K2 (VIN1 - VIN2)

where Vout3 and Vout4 are the output voltages respectively of the output OUT3 and OUT4; VIN1, VIN2, VIN3 and VIN4 are the input voltages of the four inputs, respectively IN1, IN2, IN3, IN4; K1 is a first amplification factor and K2 is a second amplification factor, with K1 greater than K2. K1 is about 26 dB and K2 is about 1 dB.
The resistance 45 and the transistor M5 are used for the biasing of the node 46.

**Claims**

1. Completely differential operational amplifier of the folded cascode type comprising:

   a differential output stage (15, 16, 17, 18, 19, 20 21, 22);
   a differential input stage (11, 12) able to drive said output stage (15, 16, 17, 18, 19, 20 21, 22);
   said differential output stage (15, 16, 17, 18, 19, 20 21, 22) includes a first branch (15, 16, 17, 18) having at least a first (16) and a second (17) transistor, and a second branch (19, 20 21, 22) having at least a third (20) and a fourth (21) transistor;
   said first (15, 16, 17, 18) and second (19, 20 21, 22) branch are coupled to a first (VDD) and to a second (GND) feeding voltage;
   a feedback circuit (40) for said first (16), second (17), third (20) and fourth (21) transistors;

   **characterized in that**
   said feedback circuit (40) is constituted by a single amplifier (40) having four inputs (IN1, IN2, IN3, IN4) and four outputs (OUT1, OUT2, OUT3, OUT4), said four inputs (IN1, IN2, IN3, IN4) take the voltage present on a terminal (23, 13, 24, 14) of said first (16), second (17), third (20) and fourth (21) transistors, and said four outputs (OUT1, OUT2, OUT3, OUT4) provide each a voltage to the control elements of said first (16), second (17), third (20) and fourth (21) transistors, which depends on the value of the input voltage of said four inputs (IN1, IN2, IN3, IN4).

2. Operational amplifier according to claim 1 **characterized in that** the dependence between an output voltage of said unique amplifier (40) and said four inputs (IN1, IN2, IN3, IN4) is according to the following relationship:

   Vout1-Vout2= K1 (VIN1 - VIN2) + K2 (VIN3 - VIN4)

   where Vout1 and Vout2 are said output voltage; VIN1, VIN2, VIN3 and VIN4 are the input voltages of said four inputs; K1 is a first amplification factor and K2 is a second amplification factor, with K1 greater than K2.

3. Operational amplifier according to claim 1 **characterized in that** said first (15, 16, 17, 18) and second (19, 20 21, 22) branch are coupled to a first (VDD) and to a second (GND) feeding voltage by means of a first (15, 19) and a second (18, 22) current mirror.

4. Operational amplifier according to claim 1 **characterized in that** said unique amplifier (40) includes

   a first differential couple composed of a first (M3) and a second (M4) transistor having the drain respectively connected to two output terminals (OUT3, OUT4) and coupled to the positive feeding voltage (VDD) by two current generators (41, 43); the gate of said first (M3) and second (M4) transistor are coupled to two input terminals (IN3, IN4);
   a second differential couple composed of a third (M1) and a fourth (M2) transistor having the drain respectively connected to two output terminals of (OUT1, OUT2) and coupled to the negative voltage feeding (GND) by two current generators (42, 44); the gate of said third (M1) and fourth (M2) transistor are coupled to two input terminals (IN1, IN2);
   the source of said first (M3), second (M4), third (M1) and fourth (M2) transistor are connected together;
   a voltage generator (45, M5) has been applied between the positive voltage feeding (VDD) and said source.

**5.** Operational amplifier according to claim 4 **characterized in that** said voltage generator (45, M5) comprises a resistance (45) in series to a transistor (M5) connected like a diode.

**6.** Amplifier having four inputs and four outputs able to provide an output voltage that depends on the value of the input voltage of said four inputs (IN1, IN2, IN3, IN4);
   **characterized in that** said amplifier includes

   a first differential couple composed of a first (M3) and a second (M4) transistor having the drain respectively connected to two output terminals (OUT3, OUT4) and coupled to the positive feeding voltage (VDD) by two current generators (41, 43); the gate of said first (M3) and second (M4) transistor are coupled to two input terminals (IN3, IN4);
   a second differential couple composed of a third (M1) and a fourth (M2) transistor having the drain respectively connected to two output terminals of (OUT1, OUT2) and coupled to the negative voltage feeding (GND) by two current generators (42, 44); the gate of said third (M1) and fourth (M2) transistor are coupled to two input terminals (IN1, IN2);
   the source of said first (M3), second (M4), third (M1) and fourth (M2) transistors are connected together;
   a voltage generator (45, M5) is applied between the positive voltage feeding (VDD) and said source.

**Patentansprüche**

**1.** Vollständig differentieller gefalteter Kaskodenoperationsverstärker mit:

   einer differentiellen Ausgangsstufe (15, 16, 17, 18, 19, 20, 21, 22);
   einer differentiellen Eingangsstufe (11, 12), die in der Lage ist, die Ausgangsstufe (15, 16, 17, 18, 19, 20, 21, 22) zu treiben;

   wobei die differentielle Ausgangsstufe (15, 16, 17, 18, 19, 20, 21, 22) einen ersten Zweig (15, 16, 17, 18) mit zumindest einem ersten (16) und einem zweiten (17) Transistor und einen zweiten Zweig (19, 20, 21, 22) mit zumindest einem dritten (20) und einem vierten (21) Transistor beinhaltet;
   der erste (15, 16, 17, 18) und der zweite (19, 20, 21, 22) Zweig mit einer ersten (VDD) und einer zweiten (GND) Versorgungsspannung verbunden sind;
   einer Rückkopplungsschaltung (40) für den ersten (16), den zweiten (17), den dritten (20) und den vierten (21) Transistor,
**dadurch gekennzeichnet, dass**
die Rückkopplungsschaltung (40) durch einen einzigen Verstärker (40) mit vier Eingängen (IN1, IN2, IN3, IN4) und vier Ausgängen (OUT1, OUT2, OUT3, OUT4) gebildet wird, die vier Eingänge (IN1, IN2, IN3, IN4) die an einem Anschluss (23, 13, 24, 14) des ersten (16), des zweiten (17), des dritten (20) und des vierten (21) Transistors vorhandene Spannung übernehmen und die vier Ausgänge (OUT1, OUT2, OUT3, OUT4) jeweils eine Spannung an das Steuerelement des ersten (16), des zweiten (17), des dritten (20) und des vierten (21) Transistors liefern, die von dem Wert der Eingangsspannung der vier Eingänge (IN1, IN2, IN3, IN4) abhängt.

**2.** Operationsverstärker nach Anspruch 1, **dadurch gekennzeichnet, dass** die Abhängigkeit zwischen einer Ausgangsspannung des einzigen Verstärkers (40) und den vier Eingängen (IN1, IN2, IN3, IN4) entsprechend der folgenden Beziehung besteht:

$$\text{Vout1-Vout2}=K1(\text{VIN1-VIN2})+K2(\text{VIN3-VIN4}),$$

   wobei Vout1 und Vout2 die Ausgangsspannung sind, VIN1, VIN2, VIN3 und VIN4 die Eingangsspannungen der vier Eingänge sind, K1 ein erster Verstärkungsfaktor ist und K2 ein zweiter Verstärkungsfaktor ist, wobei K1 größer ist als K2.

**3.** Operationsverstärker nach Anspruch 1, **dadurch gekennzeichnet, dass** der erste (15, 16, 17, 18) und der zweite (19, 20, 21, 22) Zweig mit einer ersten (VDD) und einer zweiten (GND) Versorgungsspannung mittels eines ersten (15, 19) und eines zweiten (18, 22) Stromspiegels verbunden sind.

**4.** Operationsverstärker nach Anspruch 1, **dadurch gekennzeichnet, dass** der einzige Verstärker (40) beinhaltet ein erstes differentielles Paar bestehend aus einem ersten (M3) und einem zweiten (M4) Transistor, deren Drains entsprechend mit zwei Ausgangsanschlüssen (OUT3, OUT4) verbunden sind und die mit der positiven Versorgungsspannung (VDD) über die beiden Stromquellen (41, 43) verbunden sind,
wobei die Gates des ersten (M3) und des zweiten (M4) Transistors mit zwei Eingangsanschlüssen (IN3, IN4) verbunden sind;
ein zweites differentielles Paar, das sich aus einem dritten (M1) und einem vierten (M2) Transistor zusammensetzt, deren Drains entsprechend mit zwei Ausgangsanschlüssen (OUT1, OUT2) verbunden sind und die mit der negativen Versorgungsspannung (GND) über die beiden Stromquellen (42, 44) verbunden sind,

wobei die Gates des dritten (M1) und des vierten (M2) Transistors mit zwei Eingangsanschlüssen (IN1, IN2) verbunden sind,

wobei die Source des ersten (M3), des zweiten (M4), des dritten (M1) und des vierten (M2) Transistors miteinander verbunden sind,

eine Spannungsquelle (45, M5) zwischen die positive Versorgungsspannung (VDD) und die Source geschaltet ist.

5. Operationsverstärker nach Anspruch 4, **dadurch gekennzeichnet, dass** die Spannungsquelle (45, M5) einen Widerstand (45) in Serie zu einem Transistor (M5) aufweist, der wie eine Diode geschaltet ist.

6. Verstärker mit vier Eingängen und vier Ausgängen, der in der Lage ist, eine Ausgangsspannung zu liefern, die abhängt von dem Wert der Eingangsspannung der vier Eingänge (IN1, IN2, IN3, IN4), **dadurch gekennzeichnet dass** der Verstärker beinhaltet

ein erstes differentielles Paar, das aus einem ersten (M3) und einem zweiten (M4) Transistor zusammengesetzt ist, deren Drains entsprechend mit zwei Ausgangsanschlüssen (OUT3, OUT4) verbunden sind und die mit der positiven Versorgungsspannung (VDD) über zwei Stromquellen (41, 43) verbunden sind, wobei die Gates des ersten (M3) und des zweiten (M4) Transistors mit zwei Eingangsanschlüssen (IN3, IN4) verbunden sind,

ein zweites differentielles Paar, das aus einem dritten (M1) und einem vierten (M2) Transistor zusammengesetzt ist, deren Drains entsprechend mit zwei Ausgangsanschlüssen (OUT1, OUT2) verbunden sind und mit der negativen Versorgungsspannung (GND) über zwei Stromquellen (42, 44) verbunden sind, wobei die Gates des dritten (M1) und des vierten (M2) Transistors mit zwei Eingangsanschlüssen (IN1, IN2) verbunden sind,

wobei die Source des ersten (M3), des zweiten (M4), des dritten (M1) und des vierten (M2) Transistors miteinander verbunden sind,

eine Spannungsquelle (45, M5) zwischen die positive Versorgungsspannung (VDD) und die Source geschaltet ist.

**Revendications**

1. Amplificateur opérationnel complètement différentiel de type cascode replié comprenant :

un étage de sortie différentiel (15, 16, 17, 18, 19, 20, 21, 22) ;
un étage d'entrée différentiel (11, 12) apte à piloter l'étage de sortie différentiel (15, 16, 17, 18, 19, 20, 21, 22) ;

l'étage de sortie différentiel (15, 16, 17, 18, 19, 20, 21, 22) comprenant une première branche (15, 16, 17, 18) comprenant un premier (16) et un second (17) transistor, une seconde branche (19, 20, 21, 22) comprenant au moins un troisième (20) et un quatrième (21) transistor ;
les première (15, 16, 17, 18) et seconde (19, 20, 21, 22) branches étant couplées à une première (VDD) et une seconde (GND) tension d'alimentation ;
un circuit de réaction (40) pour les premier (16), deuxième (17), troisième (20) et quatrième (21) transistors ;

**caractérisé en ce que** :

le circuit de réaction (40) est constitué d'un amplificateur unique (40) ayant quatre entrées (IN1, IN2, IN3, IN4) et quatre sorties (OUT1, OUT2, OUT3, OUT4), les quatre entrées (IN1, IN2, IN3, IN4) prennent la tension présente sur une borne (23, 13, 24, 14) des premier (16), deuxième (17), troisième (20) et quatrième (21) transistors et les quatre sorties (OUT1, OUT2, OUT3, OUT4) fournissent chacune une tension aux éléments de commande des premier (16), deuxième (17), troisième (20) et quatrième (21) transistors, qui dépendent de la valeur de la tension d'entrée des quatre entrées (IN1, IN2, IN3, IN4).

2. Amplificateur opérationnel selon la revendication 1, **caractérisé en ce que** la dépendance entre la tension de sortie de l'amplificateur unique (40) et les quatre entrées (IN1, IN2, IN3, IN4) se fait selon la relation suivante :

$$\text{Vout1} - \text{Vout2} = K1(\text{VIN1} - \text{VIN2}) + K2(\text{VIN3} - \text{VIN4})$$

où Vout1 et Vout2 sont les tensions de sortie ; VIN1, VIN2, VIN3 et VIN4 sont les tensions d'entrée des quatre entrées ; K1 est un premier facteur d'amplification ; et K2 est un second facteur d'amplification, avec K1 supérieur à K2.

3. Amplificateur opérationnel selon la revendication 1, **caractérisé en ce que** les première (15, 16, 17, 18) et seconde (19, 20, 21, 22) branches sont couplées à des première (VDD) et seconde (GND) tensions d'alimentation par un premier (15, 19) et second (18, 22) miroir de courant.

4. Amplificateur opérationnel selon la revendication 1, **caractérisé en ce que** l'amplificateur unique (40) comprend :

une première paire différentielle constituée d'un premier (M3) et d'un second (M4) transistor ayant leurs drains respectivement connectés à deux bornes de sortie (OUT3, OUT4) et couplés à la tension d'alimentation positive (VDD) par deux générateurs de courant (41, 43), les grilles du premier (M3) et du second (M4) transistor étant couplées à deux bornes d'entrée (IN3, IN4) ;

une seconde paire différentielle constituée d'un troisième (M1) et d'un quatrième (M2) transistor ayant leurs drains respectivement connectés à deux bornes de sortie (OUT1, OUT2) et couplés à l'alimentation en tension négative (GND) par deux générateurs de courant (42, 44) ; les grilles des troisième (M1) et quatrième (M2) transistors étant couplées aux deux bornes d'entrée (IN1, IN2) ;

les sources des premier (M3), deuxième (M4), troisième (M1) et quatrième (M2) transistors étant connectées les unes aux autres ;

un générateur de tension (45, M5) étant appliqué entre l'alimentation de tension positive (VDD) et ladite source.

5. Amplificateur opérationnel selon la revendication 4, **caractérisé en ce que** le générateur de tension (45, M5) comprend une résistance (45) en série avec un transistor (M5) connecté en diode.

6. Amplificateur ayant quatre entrées et quatre sorties aptes à fournir une tension de sortie qui dépend des valeurs de tension d'entrée des quatre entrées (IN1, IN2, IN3, IN4), **caractérisé en ce qu'**il comprend :

une première paire différentielle constituée d'un premier (M3) et d'un second (M4) transistor ayant leurs drains respectivement connectés à deux bornes de sortie (OUT3, OUT4) et couplés à la tension d'alimentation positive (VDD) par deux générateurs de courant (41, 43), les grilles du premier (M3) et du second (M4) transistor étant couplées à deux bornes d'entrée (IN3, IN4) ;

une seconde paire différentielle constituée d'un troisième (M1) et d'un quatrième (M2) transistor ayant leurs drains respectivement connectés à deux bornes de sortie (OUT1, OUT2) et couplés à l'alimentation en tension négative (GND) par deux générateurs de courant (42, 44) ; les grilles des troisième (M1) et quatrième (M2) transistors étant couplées aux deux bornes d'entrée (IN1, IN2) ;

les sources des premier (M3), deuxième (M4), troisième (M1) et quatrième (M2) transistors étant connectées les unes aux autres ;

un générateur de tension (45, M5) étant appliqué entre l'alimentation de tension positive (VDD) et ladite source.

Fig.1

Fig.2

VDD

GND

IN+

IN−

IN1  IN2  IN3  IN4

OUT1  OUT2  OUT3  OUT4

OUT−  OUT+

10 11 12 13 14 15 16 17 18 19 20 21 22 23 24 30 31 32 33 40

EP 1 168 602 B1

9

Fig.3

EP 1 168 602 B1

10

Fig.4